# EUROPEAN PATENT APPLICATION

(11) **EP 4 773 506 A1**
(43) Date of publication of application: **08.07.2026**
(21) Application number: 24899566.4
(22) Date of filing: 11.11.2024
(51) Int. Cl.: H03H 9/145

(54) **INTERDIGITAL TRANSDUCER STRUCTURE, FILTER STRUCTURE AND ELECTRONIC DEVICE**

(30) Priority: 05.12.2023 CN 202311655240
(71) Applicant: Maxscend Microelectronics Company Limited, Wuxi, Jiangsu 214000 (CN)
(72) Inventor: SONG, Chongxi, Wuxi, Jiangsu 214000 (CN); ZHANG, Ning, Wuxi, Jiangsu 214000 (CN); YAO, Yanlong, Wuxi, Jiangsu 214000 (CN)
(74) Representative: Murgitroyd & Company
(86) International application number: PCT/CN2024/131373
(87) International publication number: WO 2025/118924

(57) **Abstract**

Provided in the present application are an interdigital transducer structure, a filter structure and an electronic device. The interdigital transducer structure includes a plurality of first electrode fingers and a plurality of second electrode fingers, which are spaced apart from each other between two busbars, wherein weighted connecting strips are located in unipolar regions; and, in a second direction, a preset distance is present between the projection of each load structure on an electrode finger and the edge of a free end of the electrode finger. In the present application, by means of providing the weighted connecting strips in the unipolar regions and providing the load structures in an interdigital region, a transverse mode within the passband of a radio frequency filter is suppressed, and the loss is reduced. Besides this, by means of the staggered arrangement of the weighted connecting strips, the transverse mode is further suppressed. Moreover, by means of cooperation with the provision of weighted connecting posts, weighted sub-portions and auxiliary weighted portions, the suppression effect on the transverse mode is further improved. Finally, by means of using weighted transverse strips or primary weighted portions as the load structures, the suppression effect on the transverse mode is further improved.

## Description

### TECHNICAL FIELD

This present application relates to the technical field of semiconductor integrated circuit manufacturing, and in particular, to an interdigital transducer structure, a filter structure, and an electronic device.

### BACKGROUND

With the evolution of communication technologies from 2G to 5G, the number of communication frequency bands has progressively increased (rising from 4 frequency bands in 2G to more than 50 frequency bands in 5G). To enhance the compatibility of smartphones with different communication standards, the number of filters in 5G smartphones will significantly rise, driving substantial growth in the filter market. Surface acoustic wave (SAW) filters are currently widely used as radio frequency (RF) filters in wireless communication terminals, responsible for filtering RF signals in receive and transmit channels, outputting signals of specific frequencies from the input multitude of RF signals. Concurrently, with the continuous development of mobile communication technologies and the modularization of RF front-ends, demand for filters in high-end applications tends to be more complex, advanced, and miniaturized.

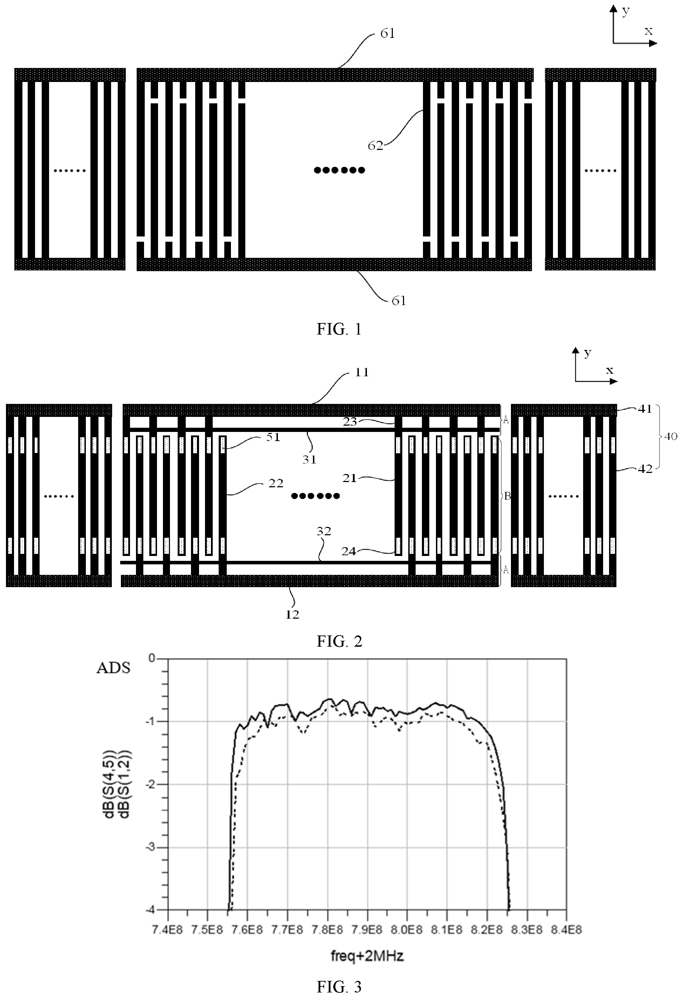

Conventional SAW (surface acoustic wave) filters are now extensively applied in RF filtering. However, for high-end devices, the performance degradation caused by transverse modes in conventional SAW structures can hardly meet the requirements of RF front-end chips. As a conventional design, the structure of a conventional SAW, as shown in FIG. 1, includes only ordinary busbars 61 and interdigital electrode fingers 62. When serving as resonators and RF filters, conventional SAWs generate strong transverse modes, which fail to satisfy the low insertion loss requirements for high-end device designs.

Therefore, there is an urgent need for a filter structure that can effectively suppress transverse modes in SAWs for RF applications.

It should be noted that the above description of the technical background is provided merely for the convenience of presenting the technical solutions of the present application in a clear and complete manner, and to facilitate understanding by those skilled in the art. It should not be considered that the above technical solutions are known to those skilled in the art simply because these solutions are described in the background section of the present application.

### SUMMARY

In view of the above disadvantages of the prior art, a purpose of the present application is to provide an interdigital transducer structure, a filter structure, and an electronic device, for solving problems of high insertion loss and poor performance caused by transverse modes in surface acoustic wave filters in radio frequency applications in the prior art.

In a first aspect, the present application provides an interdigital transducer structure. The interdigital transducer structure includes busbars, electrode fingers, weighted connecting strips, and load structures;
the busbars include a first busbar and a second busbar arranged in parallel, the electrode fingers include first electrode fingers and second electrode fingers, where the first busbar is provided with a plurality of first electrode fingers, the second busbar is provided with a plurality of second electrode fingers; the plurality of first electrode fingers and the plurality of second electrode fingers are arranged opposite to each other at intervals in an intermediate region between the first busbar and the second busbar; an end of the electrode finger connected to the busbar is defined as a connecting end, and an end of the electrode finger away from the connecting end is defined as a free end;
a direction parallel to the first busbar is defined as a first direction, a direction perpendicular to the first direction and parallel to a plane in which the interdigital transducer structure lies is defined as a second direction, and a third direction is defined as being perpendicular to both the first direction and the second direction;
the intermediate region includes an interdigital region and unipolar regions that do not belong to the interdigital region, where the interdigital region is a region formed between an edge of the free ends of the first electrode fingers and edges of the free ends of the second electrode fingers;
the weighted connecting strips are provided within the unipolar region, where the weighted connecting strip is located between the free end of the first electrode finger and the second busbar; and/or, the weighted connecting strip is located between the free end of the second electrode finger and the first busbar; and
a projection of the load structure on the electrode finger is spaced apart from the edge of the free end of the electrode finger by a preset distance in the second direction.

Optionally, the load structures are primary weighted portions, where the primary weighted portions are respectively located on surfaces of the free ends of the first electrode fingers, and/or on surfaces of the second electrode fingers at positions corresponding to the free ends of the first electrode fingers in the first direction, and/or on surfaces of the free ends of the second electrode fingers, and/or on surfaces of the first electrode fingers at positions corresponding to the free ends of the second electrode fingers in the first direction.

Optionally, each of the primary weighted portions includes at least two weighted sub-portions arranged along the second direction.

Optionally, the weighted connecting strips include a first weighted connecting strip and a second weighted connecting strip, the second weighted connecting strip and the second busbar are connected via a weighted connecting post at a position corresponding to the first electrode finger along the second direction; the first weighted connecting strip and the first busbar are connected via a weighted connecting post at a position corresponding to the second electrode finger along the second direction.

Optionally, each weighted connecting post is provided with a secondary weighted portion.

Optionally, the load structures are weighted transverse strips, where the weighted transverse strips are parallel to the first direction; one of the weighted transverse strips is arranged on a surface in the second direction close to the free end of the first electrode finger, and another of the weighted transverse strips is arranged on a surface in the second direction close to the free end of the second electrode finger.

Optionally, in the interdigital region, auxiliary weighted portions are respectively arranged on the first electrode fingers and the second electrode fingers at positions close to two weighted transverse strips; and the auxiliary weighted portion is arranged between the two weighted transverse strips, or the auxiliary weighted portion is not arranged between the two weighted transverse strips.

Optionally, the weighted connecting strips include a first weighted connecting strip and a second weighted connecting strip, where projections of the first weighted connecting strip in the first direction coincide, and projections of the second weighted connecting strip in the first direction coincide;
lengths of the first weighted connecting strip and the second weighted connecting strip parallel to the second direction are both 0.02λ-0.25λ, the minimum distance between each free end and its closest weighted connecting strip parallel to the second direction is 0.02λ-0.4λ, and the minimum distance between each free end and its closest busbar parallel to the second direction is 1λ-2λ; and
when the load structure is the primary weighted portion, a projection of each primary weighted portion on a plane in which the interdigital transducer structure lies, is located inside a projection of the electrode finger on which that primary weighted portion is located on the plane in which the interdigital transducer structure lies; a length of the electrode finger on which the primary weighted portion is located in the first direction is greater than a length of the primary weighted portion in the first direction; a length of each primary weighted portion parallel to the second direction is 0.5λ-1λ; and λ is a wavelength of a surface acoustic wave propagating within the interdigital transducer structure.

Optionally, the weighted connecting strips include first weighted connecting strips and second weighted connecting strips, where two adjacent first weighted connecting strips along the first direction are staggeredly distributed in the second direction, so that projections of the two adjacent first weighted connecting strips in the first direction do not coincide; two adjacent second weighted connecting strips along the first direction are staggeredly distributed in the second direction, so that projections of two adjacent second weighted connecting strips in the first direction do not coincide.

Optionally, the minimum distances in the second direction between two adjacent first weighted connecting strips along the first direction and their corresponding second electrode fingers are respectively 0.02λ-0.4λ and 0.1λ-0.6λ, the minimum distances in the second direction between two adjacent second weighted connecting strips along the first direction and their corresponding first electrode fingers are respectively 0.02λ-0.4λ and 0.1λ-0.6λ, and lengths of the first weighted connecting strip and the second weighted connecting strip parallel to the second direction are both 0.02λ-0.25λ; where λ is a wavelength of a surface acoustic wave propagating within the interdigital transducer structure.

In a second aspect, the present application further provides a filter structure. The filter structure includes any one of the above-mentioned interdigital transducer structures.

Optionally, the filter structure further includes two reflective grating arrays, where the two reflective grating arrays are respectively arranged on both sides of the interdigital transducer structure along the first direction; each reflective grating array includes at least two metal reflector strips and two sub-busbars, where the metal reflector strips are parallel to the second direction and arranged along the first direction; two ends of each metal reflector strip in the second direction are connected to two sub-busbars respectively; and reflective grating load structures are arranged on the reflective grating array at positions where projections of the load structures of the interdigital transducer structure in the first direction coincide.

Optionally, when the load structures of the interdigital transducer structure include primary weighted portions, the reflective grating load structures also include primary weighted portions, where the primary weighted portions of the reflective grating array are located on the metal reflector strips at positions corresponding to the primary weighted portions of the interdigital transducer structure in the first direction.

Optionally, when the primary weighted portion of the interdigital transducer structure includes at least two weighted sub-portions, each primary weighted portion on the metal reflector strip also includes at least two weighted sub-portions arranged along the second direction, where the weighted sub-portions of the reflective grating array are located on the metal reflector strip at positions corresponding to the weighted sub-portions of the interdigital transducer structure in the first direction.

Optionally, when the load structures of the interdigital transducer structure include weighted transverse strips, the reflective grating load structures also include weighted transverse strips, where the weighted transverse strips of the reflective grating array are connected to the weighted transverse strips of the interdigital transducer structure, and projections of the weighted transverse strips of the reflective grating array and the interdigital transducer structure in the first direction coincide.

Optionally, when the interdigital transducer structure is provided with an auxiliary weighted portion, the reflective grating array is also provided with an auxiliary weighted portion, and the auxiliary weighted portion of the reflective grating array is located at a position on the metal reflector strip corresponding to the auxiliary weighted portion of the interdigital transducer structure in the first direction.

In a third aspect, the present application further provides an electronic device. The electronic device includes any one of the above-mentioned filter structures.

As described above, the interdigital transducer structure, the filter structure, and the electronic device of the present application have following beneficial effects:

In the present application, by providing weighted connecting strips in the unipolar region and providing the load structures in the interdigital region, transverse modes within the passband of an RF filter can be effectively suppressed, and loss can be reduced.

Furthermore, the load structure arranged in the interdigital region, with its projection on the electrode finger having a preset distance from the edge of the free end of the electrode finger in the second direction, can improve the suppression effect of transverse modes within the passband of the RF filter, enhance the flatness within the passband, further improve the characteristics of the RF filter, and thereby enhance the performance of the RF filter.

In the present application, by staggeredly arranging the weighted connecting strips, transverse modes are further suppressed.

In the present application, by cooperating with the provision of the weighted connecting posts, the weighted sub-portions, and the auxiliary weighted portions, the suppression effect on transverse modes is further enhanced.

In the present application, by using the weighted transverse strips or the primary weighted portions as the load structures, the suppression effect on transverse modes is further enhanced.

### BRIEF DESCRIPTION OF THE DRAWINGS

FIG. 1 shows a schematic structural diagram of a conventional SAW in the prior art.
FIG. 2 shows a schematic structural diagram of an interdigital transducer structure provided with primary weighted portions according to embodiment 1 of the present application.
FIG. 3 shows a comparison chart of resonance curves of filters obtained from the prior art and the interdigital transducer structure according to embodiment 1.
FIG. 4 shows a comparison chart of resonance curves of filters obtained from the prior art and the interdigital transducer structure according to embodiment 1.
FIG. 5 shows a comparison chart of resonance curves of a filter obtained from the prior art and the interdigital transducer structure according to embodiment 1.
FIG. 6 shows a comparison chart of resonance curves of filters obtained from the prior art and the interdigital transducer structure according to embodiment 1.
FIG. 7 shows a comparison chart of resonance curves of filters obtained from the prior art and the interdigital transducer structure according to embodiment 1.
FIG. 8 shows an enlarged schematic structural diagram of the interdigital transducer structure with primary weighted portions according to embodiment 1 of the present application.
FIG. 9 shows a schematic structural diagram of an interdigital transducer structure with staggeredly distributed weighted connecting strips provided in an optional example of embodiment 1 of the present application.
FIG. 10 shows an enlarged schematic structural diagram of the interdigital transducer structure with staggeredly distributed weighted connecting strips provided in an optional example of embodiment 1 of the present application.
FIG. 11 shows a schematic structural diagram of an interdigital transducer structure with weighted sub-portions provided according to embodiment 2 of the present application.
FIG. 12 shows an enlarged schematic structural diagram of the interdigital transducer structure with weighted sub-portions provided according to embodiment 2 of the present application.
FIG. 13 shows a schematic structural diagram of an interdigital transducer structure with staggeredly distributed weighted connecting strips provided in an optional example of embodiment 2 of the present application.
FIG. 14 shows an enlarged schematic structural diagram of the interdigital transducer structure with staggeredly distributed weighted connecting strips provided in an optional example of embodiment 2 of the present application.
FIG. 15 shows a schematic structural diagram of an interdigital transducer structure with weighted connecting posts provided according to embodiment 3 of the present application.
FIG. 16 shows an enlarged schematic structural diagram of the interdigital transducer structure with weighted connecting posts provided according to embodiment 3 of the present application.
FIG. 17 shows a schematic structural diagram of an interdigital transducer structure with secondary weighted portions provided according to embodiment 4 of the present application.
FIG. 18 shows an enlarged structural schematic diagram of the interdigital transducer structure with secondary weighted portions provided according to embodiment 4 of the present application.
FIG. 19 shows a schematic structural diagram of an interdigital transducer structure with weighted transverse strips provided according to embodiment 5 of the present application.
FIG. 20 shows an enlarged schematic structural diagram of the interdigital transducer structure with weighted transverse strips provided according to embodiment 5 of the present application.
FIG. 21 shows a schematic structural diagram of an interdigital transducer structure with staggeredly distributed weighted connecting strips provided in an optional example of embodiment 5 of the present application.
FIG. 22 shows an enlarged schematic structural diagram of the interdigital transducer structure with staggeredly distributed weighted connecting strips provided in an optional example of embodiment 5 of the present application.
FIG. 23 shows a schematic structural diagram of an interdigital transducer structure with auxiliary weighted portions provided according to embodiment 6 of the present application.
FIG. 24 shows an enlarged schematic structural diagram of the interdigital transducer structure with auxiliary weighted portions provided according to embodiment 6 of the present application.
FIG. 25 shows a schematic structural diagram of an interdigital transducer structure with staggeredly distributed weighted connecting strips provided in an optional example of embodiment 6 of the present application.
FIG. 26 shows an enlarged schematic structural diagram of the interdigital transducer structure with staggeredly distributed weighted connecting strips provided in an optional example of embodiment 6 of the present application.
FIG. 27 shows a schematic structural diagram of a filter structure provided in an optional example of embodiment 7 of the present application.

### Description of reference numerals

A, unipolar region; B, interdigital region;
11, first busbar; 12, second busbar;
21, first electrode finger; 22, second electrode finger; 23, connecting end; 24, free end;
31, first weighted connecting strip; 32, second weighted connecting strip;
40, reflective grating array; 41, sub-busbar; 42, metal reflector strip;
51, primary weighted portion; 52, weighted sub-portion; 53, weighted connecting post; 54, secondary weighted portion; 55, weighted transverse strip; 56, auxiliary weighted portion;
61, ordinary busbar; 62, interdigitated electrode finger.

### DETAILED DESCRIPTION OF THE EMBODIMENTS

Embodiments of the present application are described below through specific examples. Those skilled in the art may easily understand other advantages and effects of the present application from the content disclosed in this specification. The present application may also be implemented or applied through other different specific embodiments. Various details in this specification may also be modified or changed based on different viewpoints and applications without departing from spirit of the present application.

When describing the embodiments of the present application in detail, for the convenience of explanation, schematic diagrams showing the device structure may be partially enlarged without adhering to a general scale. Moreover, the schematic diagrams are only illustrative and should not limit the scope of protection of the present application. In addition, the actual manufacturing should include three-dimensional spatial dimensions of length, width, and depth.

For ease of description, spatial relationship terms such as "under", "below", "lower than", "beneath", "above", "upper", and the like, may be used herein to describe the relationship of one element or feature shown in drawings to another elements or features. It will be understood that these spatial relationship terms are intended to encompass other orientations of the device in use or operation, in addition to orientations depicted in the drawings.

In the context of this application, a structure in which a first feature is described as being "on" a second feature may include embodiments in which the first feature and the second feature are in direct contact, and may also include embodiments in which an additional feature is formed between the first feature and the second feature, such that the first feature and the second feature may not be in direct contact.

It should be noted that the diagrams provided in the embodiments of the present application are only intended to illustrate the basic concepts of the present application in a schematic manner. Thus, the diagrams show only components related to the present application and are not drawn according to the actual number, shape, or size of components during actual implementation. In actual implementation, the form, quantity, and proportion of each component may be arbitrarily varied, and the layout of the components may also be more complex.

The "first direction" referred to in the present application is the x-direction shown in the figures, the "second direction" is the y-direction shown in the figures, and the "third direction" is the direction perpendicular to the plane of the paper, which is not shown in the figures. The directions defined herein are only for convenience of illustration, and the actual reference frame of the directions may be set according to application, all of which fall within the scope of protection of the present application.

Numerical ranges in the context of the present application all include the boundary values of the ranges.

### Embodiment 1:

As shown in FIG. 2, this embodiment provides an interdigital transducer structure. The interdigital transducer structure includes busbars, electrode fingers, weighted connecting strips, and load structures.

The busbars include a first busbar 11 and a second busbar 12 arranged in parallel. The electrode fingers include first electrode fingers 21 and second electrode fingers 22. The first busbar 11 is provided with a plurality of first electrode fingers 21, the second busbar 12 is provided with a plurality of second electrode fingers 22. The plurality of first electrode fingers 21 and the plurality of second electrode fingers 22 are arranged opposite to each other at intervals in an intermediate region between the first busbar 11 and the second busbar 12. An end of the electrode finger connected to the busbar is defined as a connecting end 23, and an end of the electrode finger away from the connecting end 23 is defined as a free end 24. A direction parallel to the first busbar 11 is defined as a first direction. A direction perpendicular to the first direction and parallel to a plane in which the interdigital transducer structure lies is defined as a second direction. A third direction is defined as being perpendicular to both the first direction and the second direction.

The intermediate region includes an interdigital region B and unipolar regions A that do not belong to the interdigital region B. The interdigital region B is a region formed between edges of the free ends 24 of the first electrode fingers 21 and edges of the free ends 24 of the second electrode fingers 22.

The weighted connecting strips are provided within the unipolar region A. The weighted connecting strip is located between the free end 24 of the first electrode finger 21 and the second busbar 12; and/or, the weighted connecting strip is located between the free end 24 of the second electrode finger 12 and the first busbar 11.

A projection of the load structure on the electrode finger is spaced apart from the edge of the free end 24 of the electrode finger by a preset distance in the second direction.

In the present application, by arranging the load structure on two end surfaces within the interdigital region B along the second direction, the acoustic velocity of the unipolar region A and the interdigital region B is adjusted through the load structures, thereby achieving maximum suppression of transverse mode ripples. Additionally, by ensuring that the projection of the load structure on the electrode finger maintains a preset distance from the edge of the free end 24 in the second direction, the cost required for the load structure is reduced, while the risk of short circuits between the electrode fingers caused by the presence of the load structure is avoided.

Furthermore, through experiments, comparative tests were conducted to evaluate whether there is a preset distance between the projection of the load structure on the electrode finger and the edge of the free end 24 in the second direction. The results indicate that when there is a preset distance between the projection of the load structure on the electrode finger and the edge of the free end 24 in the second direction, compared to cases where no such preset distance exists (i.e., the projection of the load structure on the electrode finger coincides with the edge of the free end 24, for example, when the load structure is arranged at the edge of the free end with zero distance from the edge), the suppression effect of transverse modes within a passband of a RF filter is improved, the flatness within the passband is enhanced, and the characteristics of the RF filter are further optimized, leading to improved the performance of the RF filter. Specifically, as shown in FIG. 2, the weighted connecting strips are arranged between the free end 24 of the first electrode finger 21 and the second busbar 12, and between the free end 24 of the second electrode finger 22 and the first busbar 11. Alternatively, the weighted connecting strips may also be arranged only in one of these locations.

In an embodiment, the load structure may be located on an upper surface or/and a lower surface of the electrode finger. As shown in FIG. 2, the schematic structural diagram illustrates the load structure on the upper surface of the electrode finger.

In an embodiment, an additional layer is arranged between the load structure and the electrode finger.

In an embodiment, the additional layer is a temperature compensation layer and/or a passivation layer.

In an embodiment, the load structures are primary weighted portions 51. The primary weighted portions 51 are respectively located on surfaces of the free ends 24 of the first electrode fingers 21, and/or on surfaces of the second electrode fingers 22 at positions corresponding to the free ends 24 of the first electrode fingers 21 in the first direction, and/or on surfaces of the free ends 24 of the second electrode fingers 22, and/or on surfaces of the first electrode fingers 21 at positions corresponding to the free ends 24 of the second electrode fingers 22 in the first direction.

Specifically, as shown in FIG. 2, the primary weighted portions 51 are arranged at all of the aforementioned four positions. Alternatively, the primary weighted portion 51 may be arranged at any one or any combination of more than one of these four positions, and may be adjusted and selected according to cost and performance requirements of the SAW, all of which fall within the scope of protection of the present application.

Specifically, the surface on which the primary weighted portions 51 is located includes an upper surface and/or a lower surface, or a structure with an additional layer provided between the surface. The additional layer may be a temperature compensation layer and/or a passivation layer, and the like, all of which fall within the scope of protection of the present application. FIG. 2 is a schematic structural diagram showing the primary weighted portions 51 on the upper surfaces of the electrode fingers.

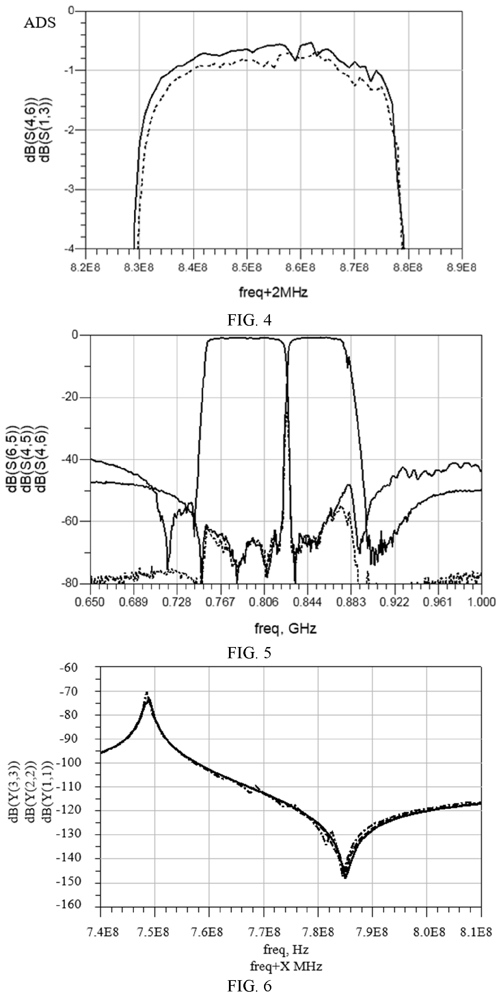

In the present application, by arranging the primary weighted portions 51 on the surfaces of the free ends 24 and on the surfaces of the corresponding electrode fingers within the interdigital region B, the acoustic wave propagation characteristics between the unipolar regions A and the interdigital region B are further improved, thereby further suppressing the transverse modes of the surface acoustic wave filter, reducing losses, and increasing quality factor. As shown in FIG. 3 to FIG. 5, comparison charts of resonance curves between a conventional SAW in the prior art and the present application, which is provided with the weighted connecting strips and the primary weighted portions 51, are presented. In the figures, the prior art is represented by dashed lines, while the solution of the present application is represented by solid lines. It may be seen that compared with the prior art, the solution of the present application significantly reduces glitches and splitting phenomena in the resonant curves. Experiment results demonstrate that a single weighted connecting strip and the primary weighted portions 51 provide better suppression of transverse mode ripples than that of a plurality of weighted connecting strips. As shown in FIG. 6 to FIG. 7, resonance curve comparisons are presented for a conventional SAW (represented by a dot-dash curve in the figure), a SAW with only primary weighted portions 51 (represented by a dashed curve in the figure), and a filter with primary weighted portions 51 and a single weighted connecting strip (represented by a solid curve in the figure). It may be seen that the filter equipped with primary weighted portions 51 and a single weighted connecting strip exhibits the smoothest resonance curve, the least amount of glitches, smaller losses on both sides of the passband, and achieves the highest quality factor.

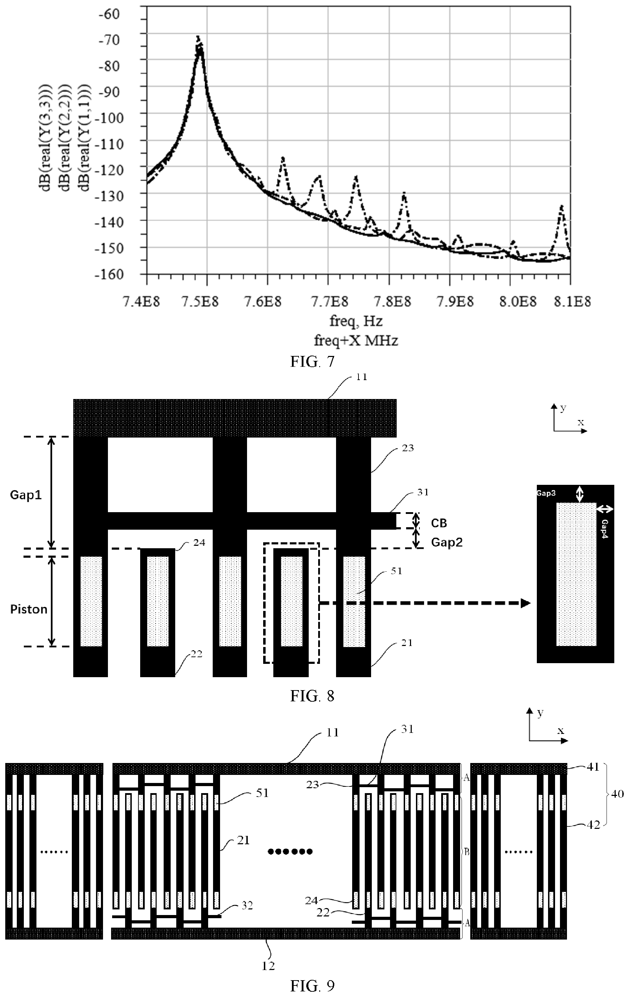

In an embodiment, FIG. 8 shows an enlarged view of the aforementioned interdigital transducer structure whose load structures are the primary weighted portions 51. The weighted connecting strips include a first weighted connecting strip 31 and a second weighted connecting strip 32. Projections of the first weighted connecting strip 31 in the first direction coincide, and projections of the second weighted connecting strip 32 in the first direction coincide.

Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ.

A projection of each primary weighted portion 51 on a plane in which the interdigital transducer structure lies, is located inside a projection of the electrode finger on which that primary weighted portion 51 is located on the plane in which the interdigital transducer structure lies. A length of the electrode finger on which the primary weighted portion 51 is located in the first direction is greater than a length of the primary weighted portion 51 in the first direction. A length Piston of each primary weighted portion 51 parallel to the second direction is 0.5λ-1λ.

The projection of each primary weighted portion 51 on the plane in which the interdigital transducer structure lies, is located inside the projection of the electrode finger on which that primary weighted portion 51 is located on the plane in which the interdigital transducer structure lies. The length of the electrode finger on which the primary weighted portion 51 is located in the first direction is greater than the length of the primary weighted portion 51 in the first direction. The minimum distance Gap3 between each primary weighted portion 51 and the edge of the electrode finger on which that primary weighted portion 51 is located and which is parallel to the first direction is 0.005λ-0.03λ. The minimum distance Gap4 between each primary weighted portion 51 and the edge of the electrode finger on which that primary weighted portion 51 is located and which is parallel to the second direction is 0.005λ**-**0.03λ.

λ is a wavelength of a surface acoustic wave propagating within the interdigital transducer structure.

In the present application, by configuring the width of the primary weighted portion 51 to be smaller than that of the electrode finger, the acoustic wave propagation mode is further optimized, and transverse mode ripples are reduced. While optimizing the performance of the SAW, the amount of the primary weighted portions 51 required is reduced, thereby decreasing the weight of the filter. This is beneficial for miniaturization and portability of SAW applications.

In an embodiment, the primary weighted portion 51 is a laminated structure of chromium, copper, and chromium in the third direction from top to bottom; or the primary weighted portion 51 is a laminated structure of chromium, silver, and chromium in the third direction from top to bottom.

In the present application, by configuring the material of the primary weighted portion 51 as a laminated structure of chromium/copper/chromium or chromium/silver/chromium, the suppression of transverse modes by the primary weighted portions 51 is further optimized. Experiments with various materials have shown that using the laminated structures of chromium/copper/chromium and chromium/silver/chromium as the material for the primary weighted portion 51 may achieve optimal performance, while also improving the adhesion between the primary weighted portion 51 on the electrode finger.

In an embodiment, as shown in FIG. 9, the weighted connecting strips include first weighted connecting strips 31 and second weighted connecting strips 32. Two adjacent first weighted connecting strips 31 along the first direction are staggeredly distributed in the second direction, so that projections of the two adjacent first weighted connecting strips 31 in the first direction do not coincide; two adjacent second weighted connecting strips 32 along the first direction are staggeredly distributed in the second direction, so that projections of the two adjacent second weighted connecting strips 32 in the first direction do not coincide.

In the present application, by arranging the weighted connecting strips in a staggeredly distributed structure, influence of the weighted connecting strips on the acoustic wave propagation characteristics between the unipolar regions A and the interdigital region B is further enhanced, thereby further optimizing the suppression effect on transverse modes.

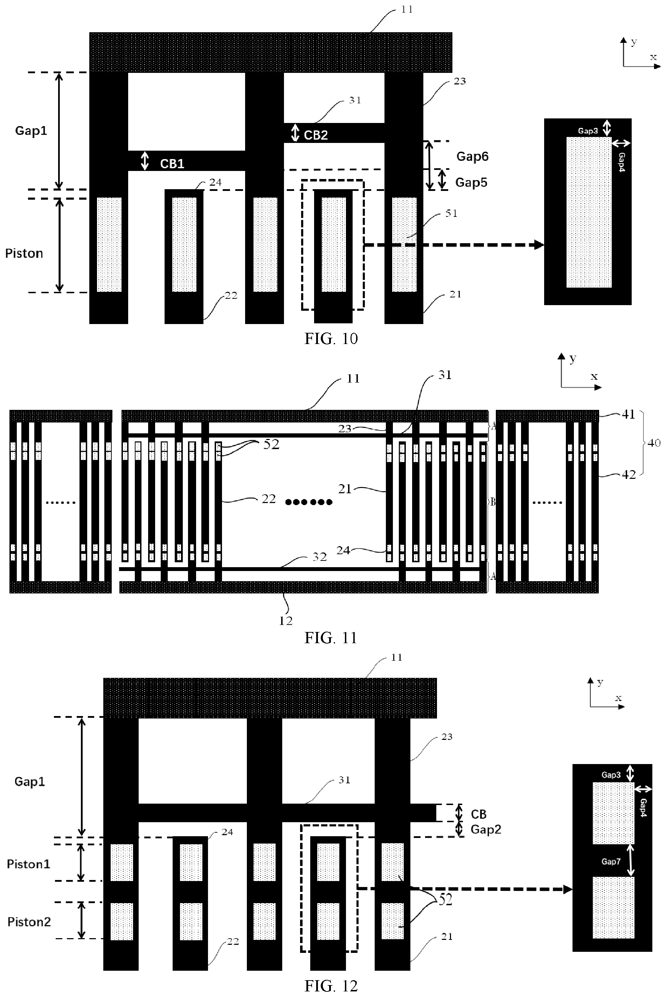

In an embodiment, as shown in FIG. 10, which is an enlarged view of the aforementioned interdigital transducer structure provided with staggeredly distributed weighted connecting strips 31. The minimum distances Gap5 and Gap6 in the second direction between two adjacent first weighted connecting strips 31 along the first direction and their corresponding second electrode fingers 22 are respectively 0.02λ-0.4λ and 0.1λ-0.6λ. The minimum distances Gap5 and Gap6 in the second direction between two adjacent second weighted connecting strips 32 along the first direction and their corresponding first electrode fingers 21 are respectively 0.02λ-0.4λ and 0.1λ-0.6λ. Lengths CB1 and CB2 of the first weighted connecting strip 31 and the second weighted connecting strip 32 parallel to the second direction are both 0.02λ-0.25λ. The minimum distance Gap1 between each free end 24 and its closest busbar parallel to the second direction is 1λ-2λ.

A projection of each primary weighted portion 51 on a plane in which the interdigital transducer structure lies, is located inside a projection of the electrode finger on which that primary weighted portion 51 is located on the plane in which the interdigital transducer structure lies. A length of the electrode finger on which the primary weighted portion 51 is located in the first direction is greater than a length of the primary weighted portion 51 in the first direction. A length Piston of each primary weighted portion 51 parallel to the second direction is 0.5λ-1λ.

The projection of each primary weighted portion 51 on the plane in which the interdigital transducer structure lies, is located inside the projection of the electrode finger on which that primary weighted portion 51 is located on the plane in which the interdigital transducer structure lies. The length of the electrode finger on which the primary weighted portion 51 is located in the first direction is greater than the length of the primary weighted portion 51 in the first direction. The minimum distance Gap3 between each primary weighted portion 51 and the edge of the electrode finger on which that primary weighted portion 51 is located and which is parallel to the first direction is 0.005λ**-**0.03λ. The minimum distance Gap4 between each primary weighted portion 51 and the edge of the electrode finger on which that primary weighted portion 51 is located and which is parallel to the second direction is 0.005λ**-**0.03λ. λ is a wavelength of a surface acoustic wave propagating within the interdigital transducer structure.

In an embodiment, projections of two spaced-apart first weighted connecting strips 31 in the first direction coincide, and/or projections of two spaced-apart second weighted connecting strips 32 in the first direction coincide.

In an embodiment, projections of two spaced-apart first weighted connecting strips 31 in the first direction do not coincide, and/or projections of two spaced-apart second weighted connecting strips 32 in the first direction do not coincide.

This embodiment may also be combined with any one or more features from other embodiments to obtain new structures, and all such resulting structures fall within the scope of protection of the present application.

### Embodiment 2:

This embodiment provides an interdigital transducer structure. The interdigital transducer structure is the same as the interdigital transducer structure in embodiment 1 in other features, and the difference lies in that:

Each of the primary weighted portions 51 includes at least two weighted sub-portions 52 arranged along the second direction.

In the present application, by further improving the primary weighted portion 51 to form a structure divided into two weighted sub-portions 52, the acoustic wave propagation characteristics between the unipolar regions A and the interdigital region B are further improved, thereby optimizing the suppression effect on transverse modes.

In an embodiment, as shown in FIG. 11, each of the primary weighted portions 51 includes two weighted sub-portions 52 arranged along the second direction.

In an embodiment, a plurality of weighted sub-portions 52 may also be arranged in different arrays, and the specific configuration may be adjusted according to actual structural requirements and experimental effects.

In an embodiment, the weighted connecting strips include a first weighted connecting strip 31 and a second weighted connecting strip 32. Projections of the first weighted connecting strip 31 in the first direction coincide, and projections of the second weighted connecting strip 32 in the first direction coincide.

As shown in FIG. 12, which is an enlarged view of the aforementioned interdigital transducer structure provided with at least two weighted sub-portions 52. Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ.

Projections of the two weighted sub-portions 52 on a plane in which the interdigital transducer structure lies, are located inside a projection of the electrode finger on which the two weighted sub-portions 52 are located on the plane in which the interdigital transducer structure lies. A length of the electrode finger on which the two weighted sub-portions 52 are located in the first direction is greater than a total length of the two weighted sub-portions 52 in the first direction.

Lengths Piston1 and Piston2 of the two weighted sub-portions 52 in the second direction are both 0.2λ-1λ. The minimum distance Gap7 between the two weighted sub-portions 52 in the second direction is 0.1λ-1λ. The minimum distance Gap3 between each weighted sub-portion 52 and the edge of the electrode finger on which that weighted sub-portion 52 is located and which is parallel to the first direction is 0.005λ**-**0.03λ. The minimum distance Gap4 between each weighted sub-portion 52 and the edge of the electrode finger on which that weighted sub-portion 52 is located and which is parallel to the second direction is 0.005λ**-**0.03λ.

λ is the wavelength of the surface acoustic wave propagating within the interdigital transducer structure.

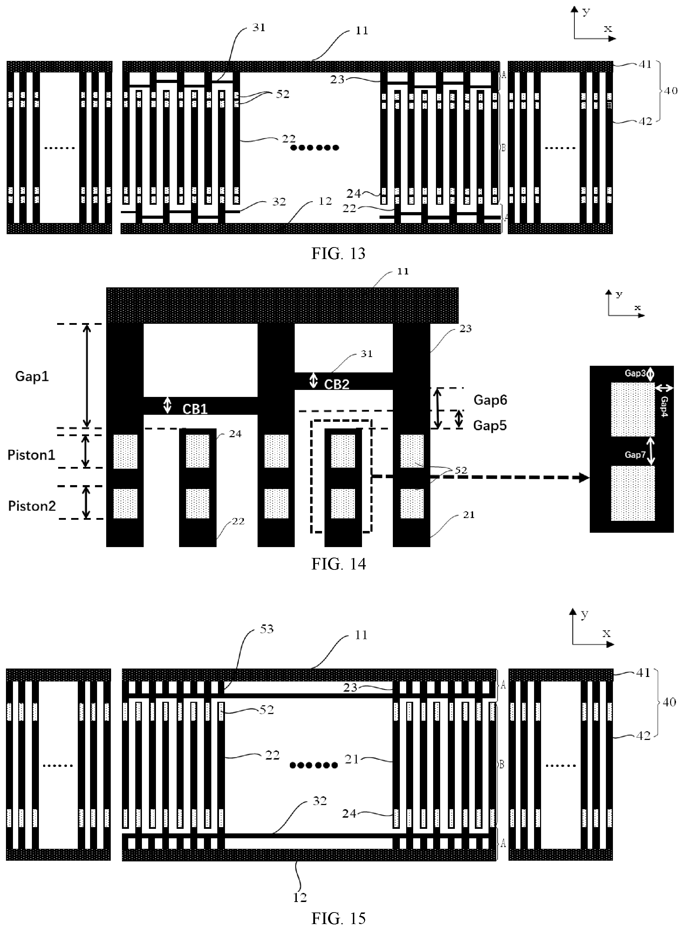

In an embodiment, as shown in FIG. 13, the weighted connecting strips include first weighted connecting strips 31 and second weighted connecting strips 32. Two adjacent first weighted connecting strips 31 along the first direction are staggeredly distributed in the second direction, so that projections of the two adjacent first weighted connecting strips 31 in the first direction do not coincide; two adjacent second weighted connecting strips 32 along the first direction are staggeredly distributed in the second direction, so that projections of the two adjacent second weighted connecting strips 32 in the first direction do not coincide.

In the present application, by arranging the weighted connecting strips in a staggeredly distributed structure, influence of the weighted connecting strips on the acoustic wave propagation characteristics between the unipolar regions A and the interdigital region B is further enhanced, thereby further optimizing the suppression effect on transverse modes.

In an embodiment, as shown in FIG. 14, which is an enlarged view of the aforementioned interdigital transducer structure provided with staggeredly distributed weighted connecting strips 31. The minimum distances Gap5 and Gap6 in the second direction between two adjacent first weighted connecting strips 31 along the first direction and their corresponding second electrode fingers 22 are respectively 0.02λ-0.4λ and 0.1λ-0.6λ. The minimum distances Gap5 and Gap6 in the second direction between two adjacent second weighted connecting strips 32 along the first direction and their corresponding first electrode fingers 21 are respectively 0.02λ-0.4λ and 0.1λ-0.6λ. Lengths CB1 and CB2 of the first weighted connecting strip 31 and the second weighted connecting strip 32 parallel to the second direction are both 0.02λ-0.25λ. The minimum distance Gap1 between each free end 24 and its closest busbar parallel to the second direction is 1λ-2λ.

Projections of the two weighted sub-portions 52 on a plane in which the interdigital transducer structure lies, are located inside a projection of the electrode finger on which the two weighted sub-portions 52 are located on the plane in which the interdigital transducer structure lies. A length of the electrode finger on which the two weighted sub-portions 52 are located in the first direction is greater than a total length of the two weighted sub-portions 52 in the first direction.

Lengths Piston1 and Piston2 of the two weighted sub-portions 52 in the second direction are both 0.2λ-1λ. The minimum distance Gap7 between the two weighted sub-portions 52 in the second direction is 0.1λ-1λ. The minimum distance Gap3 between each weighted sub-portion 52 and the edge of the electrode finger on which that weighted sub-portion 52 is located and which is parallel to the first direction is 0.005λ**-**0.03λ. The minimum distance Gap4 between each weighted sub-portion 52 and the edge of the electrode finger on which that weighted sub-portion 52 is located and which is parallel to the second direction is 0.005λ**-**0.03λ.

λ is the wavelength of the surface acoustic wave propagating within the interdigital transducer structure.

In an embodiment, projections of two spaced-apart first weighted connecting strips 31 in the first direction coincide, and/or projections of two spaced-apart second weighted connecting strips 32 in the first direction coincide.

In an embodiment, projections of two spaced-apart first weighted connecting strips 31 in the first direction do not coincide, and/or projections of two spaced-apart second weighted connecting strips 32 in the first direction do not coincide.

This embodiment may also be combined with any one or more features from other embodiments to obtain new structures, and all such resulting structures fall within the scope of protection of the present application.

### Embodiment 3:

This embodiment provides an interdigital transducer structure. The interdigital transducer structure is the same as the interdigital transducer structure in embodiment 1 or embodiment 2 in other features, and the difference lies in that:

The weighted connecting strips include a first weighted connecting strip 31 and a second weighted connecting strip 32. The second weighted connecting strip 32 and the second busbar 12 are connected via a weighted connecting post 53 at a position corresponding to the first electrode finger 21 along the second direction. The first weighted connecting strip 31 and the first busbar 11 are connected via a weighted connecting post 53 at a position corresponding to the second electrode finger 22 along the second direction.

In the present application, by arranging the weighted connecting post 53 between adjacent weighted connecting strips and busbars to connect them, the acoustic wave propagation characteristics between the unipolar regions A and the interdigital region B are further improved, thereby optimizing the suppression effect on transverse modes.

In an embodiment, as shown in FIG. 15, the weighted connecting strips include a first weighted connecting strip 31 and a second weighted connecting strip 32. Projections of the first weighted connecting strip 31 in the first direction coincide, and projections of the second weighted connecting strip 32 in the first direction coincide.

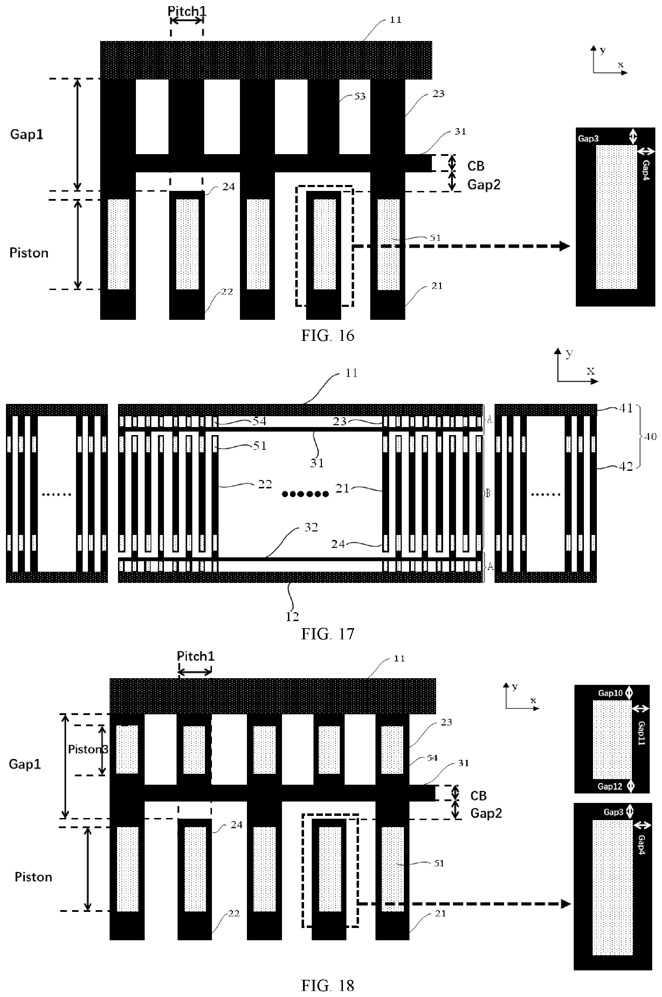

In an embodiment, as shown in FIG. 16, which is an enlarged view of the aforementioned interdigital transducer structure provided with the weighted connecting posts 53. The minimum distance Gap3 between each primary weighted portion 51 and the edge of the electrode finger on which that primary weighted portion 51 is located and which is parallel to the first direction is 0.005λ**-**0.03λ. The minimum distance Gap4 between each primary weighted portion 51 and the edge of the electrode finger on which that primary weighted portion 51 is located and which is parallel to the second direction is 0.005λ**-**0.03λ. A length Pitch1 of the weighted connecting post 53 in the first direction corresponding to the first electrode finger 21 is the same as that of the first electrode finger 21. The length Pitch1 of the weighted connecting post 53 in the first direction corresponding to the second electrode finger 22 is the same as that of the second electrode finger 22. λ is a wavelength of the surface acoustic wave propagating within the interdigital transducer structure.

Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ.

When the load structures are the primary weighted portions 51, the projection of each primary weighted portion 51 on a plane in which the interdigital transducer structure lies, is located inside the projection of the electrode finger on which that primary weighted portion 51 is located on the plane in which the interdigital transducer structure lies. A length of the electrode finger on which the primary weighted portion 51 is located in the first direction is greater than a length of the primary weighted portion 51 in the first direction. A length Piston of each primary weighted portion 51 parallel to the second direction is 0.5λ-1λ.

λ is a wavelength of the surface acoustic wave propagating within the interdigital transducer structure.

In an embodiment, projections of two spaced-apart first weighted connecting strips 31 in the first direction coincide, and/or projections of two spaced-apart second weighted connecting strips 32 in the first direction coincide.

In an embodiment, projections of two spaced-apart first weighted connecting strips 31 in the first direction do not coincide, and/or projections of two spaced-apart second weighted connecting strips 32 in the first direction do not coincide.

This embodiment may also be combined with any one or more features of other embodiments to obtain new structures, and all such resulting structures fall within the scope of protection of the present application.

### Embodiment 4:

This embodiment provides an interdigital transducer structure. The interdigital transducer structure is the same as the interdigital transducer structure in embodiment 3 in other features, and the difference lies in that:

Each weighted connecting post 53 is provided with a secondary weighted portion 54.

In the present application, by arranging the secondary weighted portions 54 on the weighted connecting post 53, the acoustic wave propagation characteristics between the unipolar regions A and the interdigital region B are further improved, thereby optimizing the suppression effect on transverse modes.

In an embodiment, as shown in FIG. 17, the weighted connecting strips include a first weighted connecting strip 31 and a second weighted connecting strip 32. Projections of the first weighted connecting strip 31 in the first direction coincide, and projections of the second weighted connecting strip 32 in the first direction coincide.

In an embodiment, as shown in FIG. 18, which is an enlarged view of the aforementioned interdigital transducer structure provided with the secondary weighted portion 54. A length Piston3 of the secondary weighted portion 54 in the second direction is 0.2λ-1λ. The minimum distance Gap10 between each secondary weighted portion 54 and its closest busbar in the first direction is 0.005λ**-**0.03λ. The minimum distance Gap11 between each secondary weighted portion 54 and an edge of the electrode finger on which that secondary weighted portion 54 is located and which is parallel to the second direction is 0.005λ**-**0.03λ. The minimum distance Gap12 between each secondary weighted portion 54 and its closest weighted connecting strip in the first direction is 0.005λ-0.03λ. The minimum distance Gap3 between each primary weighted portion 51 and an edge of the electrode finger on which that primary weighted portion 51 is located and which is parallel to the first direction is 0.005λ**-**0.03λ. The minimum distance Gap4 between each primary weighted portion 51 and an edge of the electrode finger on which that primary weighted portion 51 is located and which is parallel to the second direction is 0.005λ**-**0.03λ.

Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ.

When the load structures are the primary weighted portions 51, the projection of each primary weighted portion 51 on a plane in which the interdigital transducer structure lies, is located inside the projection of the electrode finger on which that primary weighted portion 51 is located on the plane in which the interdigital transducer structure lies. A length of the electrode finger on which the primary weighted portion 51 is located in the first direction is greater than a length of the primary weighted portion 51 in the first direction. A length Piston of each primary weighted portion 51 parallel to the second direction is 0.5λ-1λ.

λ is a wavelength of the surface acoustic wave propagating within the interdigital transducer structure.

This embodiment may also be combined with any one or more features of other embodiments to obtain new structures, and all such resulting structures fall within the scope of protection of the present application.

### Embodiment 5:

This embodiment provides an interdigital transducer structure. The interdigital transducer structure is the same as the interdigital transducer structure in embodiment 1, embodiment 3, or embodiment 4 in other features, and the difference lies in that:

The load structures are weighted transverse strips 55. The weighted transverse strips 55 are parallel to the first direction. One of the weighted transverse strips 55 is arranged on a surface in the second direction close to the free end 24 of the first electrode finger 21, and another of the weighted transverse strips 55 is arranged on a surface in the second direction close to the free end 24 of the second electrode finger 22.

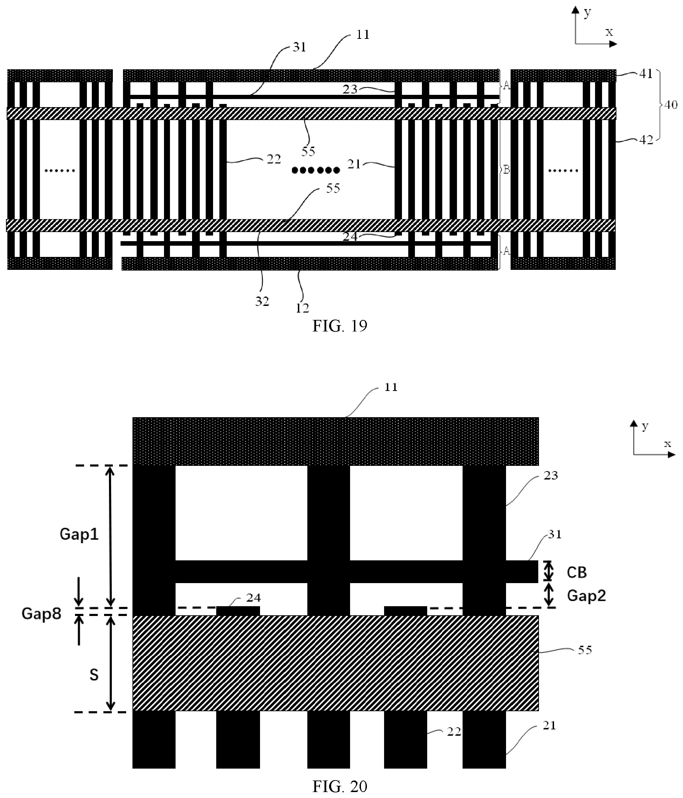

Specifically, the surface on which the weighted transverse strip 55 is located includes an upper surface and/or a lower surface, or a structure with an additional layer provided between the surface. The additional layer may be a temperature compensation layer and/or a passivation layer, and the like, all of which fall within the scope of protection of the present application. FIG. 19 to FIG. 22 are schematic structural diagrams showing the weighted transverse strips 55 on the upper surfaces of the electrode fingers.

In the present application, by arranging the weighted transverse strip 55 within the interdigital region B, the acoustic wave propagation characteristics between the unipolar regions A and the interdigital region B are improved, thereby optimizing the suppression effect on transverse modes.

In an embodiment, a distance Gap8 in the second direction between the weighted transverse strip 55 and the edge of its adjacent free end 24 is 0.005λ**-**0.03λ. A length S of the weighted transverse strip 55 in the second direction is 0.5λ-1λ.

In an embodiment, the material of the weighted transverse strip 55 is silicon dioxide.

In an embodiment, as shown in FIG. 19, projections of the first weighted connecting strips 31 in the second direction coincide, and projections of the second weighted connecting strip 32 in the second direction coincide.

In an embodiment, as shown in FIG. 20, which is an enlarged view of the aforementioned interdigital transducer structure provided with the weighted transverse strip 55. Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ. A distance Gap8 in the second direction between the weighted transverse strip 55 and the edge of its adjacent free end 24 is 0.005λ**-**0.03λ. A length S of the weighted transverse strip 55 in the second direction is 0.5λ-1λ.

λ is a wavelength of a surface acoustic wave propagating within the interdigital transducer structure.

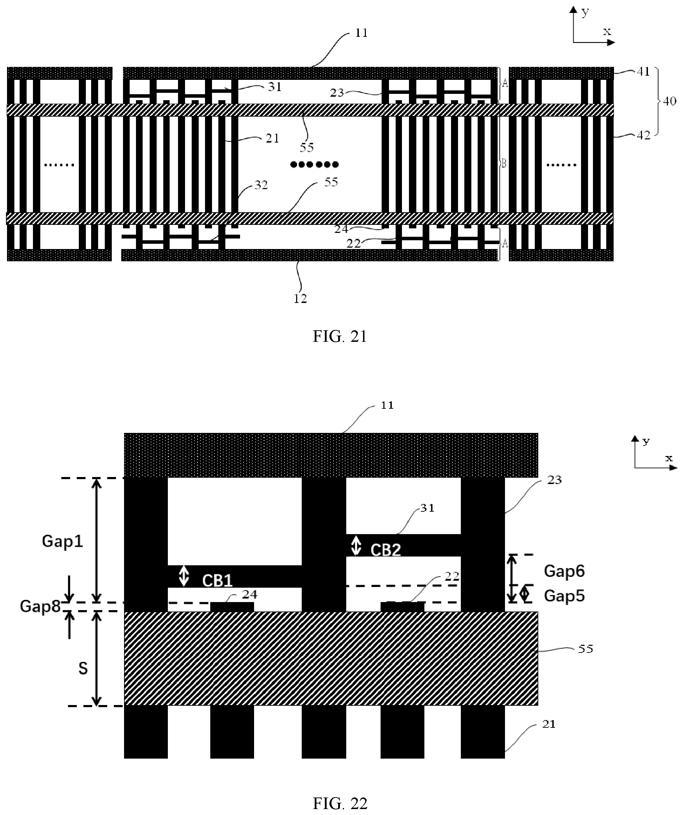

In an embodiment, as shown in FIG. 21, the weighted connecting strips include first weighted connecting strips 31 and second weighted connecting strips 32. Two adjacent first weighted connecting strips 31 along the first direction are staggeredly distributed in the second direction, so that projections of the two adjacent first weighted connecting strips 31 in the first direction do not coincide; two adjacent second weighted connecting strips 32 along the first direction are staggeredly distributed in the second direction, so that projections of the two adjacent second weighted connecting strips 32 in the first direction do not coincide.

In the present application, by arranging the weighted connecting strips in a staggeredly distributed structure, influence of the weighted connecting strips on the acoustic wave propagation characteristics between the unipolar regions A and the interdigital region B is further enhanced, thereby further optimizing the suppression effect on transverse modes.

In an embodiment, as shown in FIG. 22, which is an enlarged view of the aforementioned interdigital transducer structure provided with staggeredly distributed weighted connecting strips. The distance Gap8 in the second direction between the weighted transverse strip 55 and the edge of its adjacent free end 24 is 0.005λ-0.03λ, and the length S of the weighted transverse strip 55 in the second direction is 0.5λ-1λ. The minimum distance Gap1 between each free end 24 and its closest busbar parallel to the second direction is 1λ-2λ. The minimum distances Gap5 and Gap6 in the second direction between two adjacent first weighted connecting strips 31 along the first direction and their corresponding second electrode fingers 22 are respectively 0.02λ-0.4λ and 0.1λ-0.6λ. The minimum distances Gap5 and Gap6 in the second direction between two adjacent second weighted connecting strips 32 along the first direction and their corresponding first electrode fingers 21 are respectively 0.02λ-0.4λ and 0.1λ-0.6λ. Lengths CB1 and CB2 of the first weighted connecting strip 31 and the second weighted connecting strip 32 parallel to the second direction are both 0.02λ-0.25λ. λ is the wavelength of the surface acoustic wave propagating within the interdigital transducer structure.

In an embodiment, projections of two spaced-apart first weighted connecting strips 31 in the first direction coincide, and/or projections of two spaced-apart second weighted connecting strips 32 in the first direction coincide.

In an embodiment, projections of two spaced-apart first weighted connecting strips 31 in the first direction do not coincide, and/or projections of two spaced-apart second weighted connecting strips 32 in the first direction do not coincide.

This embodiment may also be combined with any one or more features from other embodiments to obtain new structures, and all such resulting structures fall within the scope of protection of the present application.

### Embodiment 6:

This embodiment provides an interdigital transducer structure. The interdigital transducer structure is the same as the interdigital transducer structure in embodiment 5 in other features, and the difference lies in that:

In the interdigital region B, auxiliary weighted portions 56 are respectively arranged on the first electrode fingers 21 and the second electrode fingers 22 at positions close to the two weighted transverse strips 55. The auxiliary weighted portion 56 is arranged between the two weighted transverse strips 55, or the auxiliary weighted portion 56 is not arranged between the two weighted transverse strips 55.

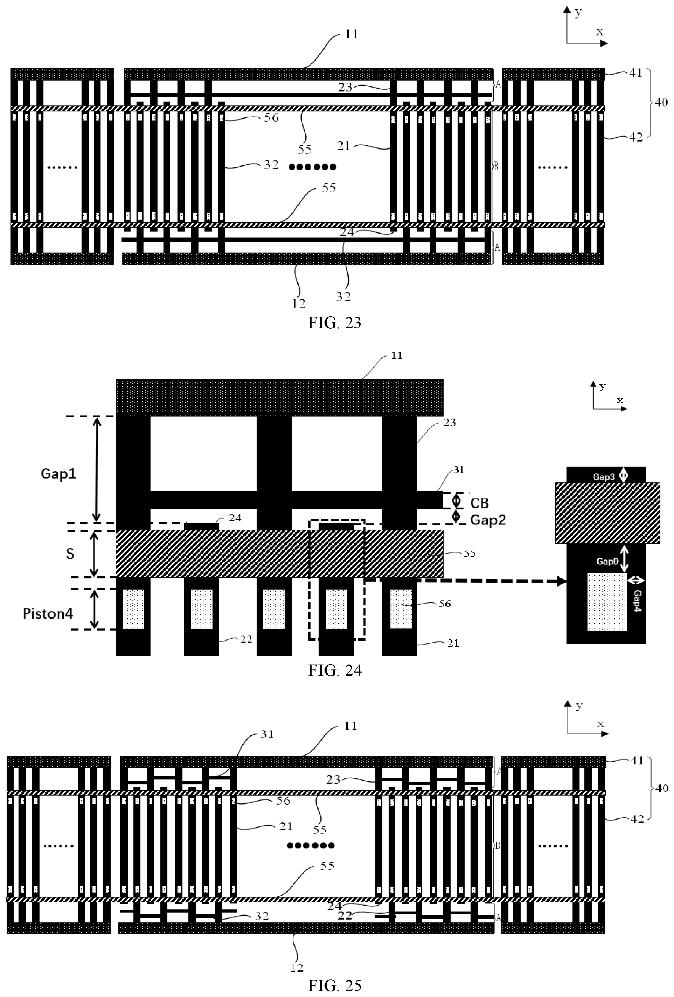

In an embodiment, as shown in FIG. 23, the weighted connecting strips include the first weighted connecting strip 31 and the second weighted connecting strip 32. Projections of the first weighted connecting strip 31 in the first direction coincide, and projections of the second weighted connecting strip 32 in the first direction coincide.

In an embodiment, as shown in FIG. 24, which is an enlarged view of the aforementioned interdigital transducer structure provided with the auxiliary weighted portion 56. The minimum distance Gap9 in the second direction between the auxiliary weighted portion 56 and its adjacent weighted transverse strip 55 is 0.1λ-0.5λ. The minimum distance Gap3 between the weighted transverse strip 55 and the edge of the free end of its adjacent electrode finger that is parallel to the first direction is 0.005λ**-**0.03λ. The minimum distance Gap4 between each auxiliary weighted portion 56 and the edge of the electrode finger on which that auxiliary weighted portion 56 is located and which is parallel to the second direction is 0.005λ**-**0.03λ. A length S of the weighted transverse strip 55 in the second direction is 0.2λ-1λ, and a length Piston4 of the auxiliary weighted portion 56 in the second direction is 0.2λ-1λ. Lengths CB of the first weighted connecting strip 31 and the second weighted connecting strip 32 parallel to the second direction are both 0.02λ-0.25λ. The minimum distance Gap2 between each free end 24 and its closest weighted connecting strip parallel to the second direction is 0.02λ-0.4λ. The minimum distance Gap1 between each free end 24 and its closest busbar parallel to the second direction is 1λ-2λ.

λ is a wavelength of a surface acoustic wave propagating within the interdigital transducer structure.

In an embodiment, the auxiliary weighted portions 56 are arranged between the two weighted transverse strips 55, or the auxiliary weighted portion 56 is not arranged between the two weighted transverse strips 55. That is, an order of the auxiliary weighted portion 56 and the weighted transverse strip 55 to which it is close in the second direction can be interchanged.

In an embodiment, as shown in FIG. 25, the weighted connecting strips include first weighted connecting strips 31 and second weighted connecting strips 32. Two adjacent first weighted connecting strips 31 along the first direction are distributed staggeredly in the second direction, so that projections of the two adjacent first weighted connecting strips 31 in the first direction do not coincide; two adjacent second weighted connecting strips 32 along the first direction are staggeredly distributed in the second direction, so that projections of the two adjacent second weighted connecting strips 32 in the first direction do not coincide.

In the present application, by arranging the weighted connecting strips in a staggeredly distributed structure, influence of the weighted connecting strips on the acoustic wave propagation characteristics between the unipolar regions A and the interdigital region B is further enhanced, thereby further optimizing the suppression effect on transverse modes.

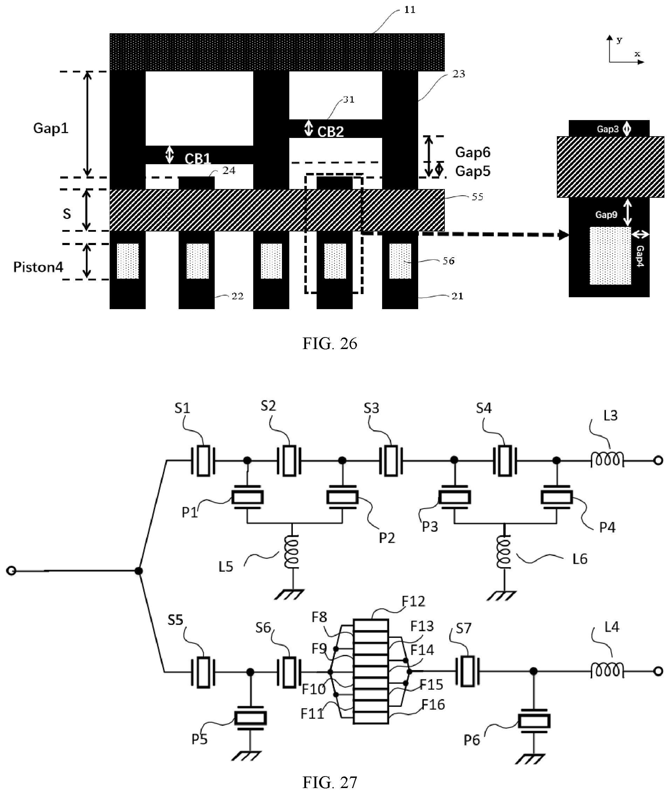

In an embodiment, as shown in FIG. 26, which is an enlarged view of the aforementioned interdigital transducer structure provided with staggeredly distributed weighted connecting strips. The minimum distance Gap9 in the second direction between the auxiliary weighted portion 56 and its adjacent weighted transverse strip 55 is 0.1λ-0.5λ. The minimum distance Gap3 between the weighted transverse strip 55 and the edge of the free end of its adjacent electrode finger that is parallel to the first direction is 0.005λ**-**0.03λ. The minimum distance Gap4 between each auxiliary weighted portion 56 and the edge of the electrode finger on which each auxiliary weighted portion 56 is located and which is parallel to the second direction is 0.005λ**-**0.03λ. A length S of the weighted transverse strip 55 in the second direction is 0.2λ-1λ, and a length Piston4 of the auxiliary weighted portion 56 in the second direction is 0.2λ-1λ. The minimum distance Gap1 between each free end 24 and its closest busbar parallel to the second direction is 1λ-2λ. The minimum distances Gap5 and Gap6 in the second direction between two adjacent first weighted connecting strips 31 along the first direction and their corresponding second electrode fingers 22 are respectively 0.02λ-0.4λ and 0.1λ-0.6λ. The minimum distances Gap5 and Gap6 in the second direction between two adjacent second weighted connecting strips 32 along the first direction and their corresponding first electrode strips 21 are respectively 0.02λ-0.4λ and 0.1λ-0.6λ. Lengths CB1 and CB2 of the first weighted connecting strip 31 and the second weighted connecting strip 32 parallel to the second direction are both 0.02λ-0.25λ. λ is the wavelength of the surface acoustic wave propagating within the interdigital transducer structure.

In an embodiment, projections of two spaced-apart first weighted connecting strips 31 in the first direction coincide, and/or projections of two spaced-apart second weighted connecting strips 32 in the first direction coincide.

In an embodiment, projections of two spaced-apart first weighted connecting strips 31 in the first direction do not coincide, and/or projections of two spaced-apart second weighted connecting strips 32 in the first direction do not coincide.

This embodiment may also be combined with any one or more features from other embodiments to obtain new structures, and all such resulting structures fall within the scope of protection of the present application.

### Embodiment 7:

This embodiment provides a filter structure. The filter structure includes any one of the interdigital transducer structures from embodiment 1 to embodiment 6.

In an embodiment, as shown in FIG. 27, the filter structure is a topology structure including a duplexer formed by nine of the interdigital transducer structures F8-F16, parallel resonators P1-P6, series resonators S1-S7, and inductors L3-L6.

Specifically, the interdigital transducer structure is usually applied for filtering in a receiving-end frequency band within the filter structure.

In an embodiment, the filter structure further includes two reflective grating arrays 40. The two reflective grating arrays 40 are respectively arranged on both sides of the interdigital transducer structure along the first direction. Each reflective grating array 40 includes at least two metal reflector strips 42 and two sub-busbars 41. The metal reflector strips 42 are parallel to the second direction and arranged along the first direction. Two ends of each metal reflector strip 42 in the second direction are connected to two sub-busbars 41 respectively. On the reflective grating array 40, at positions where the projections of the load structures of the interdigital transducer structure in the first direction coincide, reflective grating load structures are provided.

In the present application, by providing the reflective grating arrays 40, the reflection efficiency of the filter is improved.

In an embodiment, as shown in FIG. 2, when the load structures of the interdigital transducer structure include the primary weighted portions 51, the reflective grating load structures also include the primary weighted portions 51. The primary weighted portions 51 of the reflective grating array 40 are located on the metal reflector strips 42 at positions corresponding to the primary weighted portions 51 of the interdigital transducer structure in the first direction.

In the present application, by providing the primary weighted portions 51 corresponding to the interdigital transducer structure at corresponding positions on the reflective grating array 40, the reflection efficiency of the filter is further improved.

This embodiment may also be combined with any one or more features from other embodiments to obtain new structures, and all such resulting structures fall within the scope of protection of the present application.

### Embodiment 8:

This embodiment provides a filter structure. The filter structure is the same as the filter structure in embodiment 7 in other features, and the difference lies in that:

As shown in FIG. 11, when the primary weighted portion 51 of the interdigital transducer structure includes at least two weighted sub-portions 52, each primary weighted portion 51 on the metal reflector strip 42 also includes at least two weighted sub-portions 52 arranged along the second direction. The weighted sub-portions 52 of the reflective grating array 40 are located on the metal reflector strip 42 at positions corresponding to the weighted sub-portions 52 of the interdigital transducer structure in the first direction.

In the present application, by providing at least two weighted sub-portions 52 corresponding to the interdigital transducer structure at corresponding positions on the reflective grating array 40, the reflection efficiency of the filter is further improved.

This embodiment may also be combined with any one or more features from other embodiments to obtain new structures, and all such resulting structures fall within the scope of protection of the present application.

### Embodiment 9:

This embodiment provides a filter structure. The filter structure is the same as the filter structure in embodiment 7 in other features, and the difference lies in that:

As shown in FIG. 19, when the load structures of the interdigital transducer structure include the weighted transverse strips 55, the reflective grating load structures also include the weighted transverse strips 55. The weighted transverse strips 55 of the reflective grating array 40 are connected to the weighted transverse strips 55 of the interdigital transducer structure and their projections in the first direction coincide.

In the present application, by arranging the weighted transverse strips 55 corresponding to the interdigital transducer structure at corresponding positions on the reflective grating array 40, the reflection efficiency of the filter is further improved.

This embodiment may also be combined with any one or more features from other embodiments to obtain new structures, and all such resulting structures fall within the scope of protection of the present application.

### Embodiment 10:

This embodiment provides a filter structure. The filter structure is the same as the filter structure in embodiment 9 in other features, and the difference lies in that:

As shown in FIG. 23, when the auxiliary weighted portions 56 are provided on the interdigital transducer structure, the reflective grating array 40 is also provided with the auxiliary weighted portions 56. The auxiliary weighted portions 56 of the reflective grating array 40 are located on the metal reflector strip 42 at positions corresponding to the auxiliary weighted portions 56 of the interdigital transducer structure in the first direction.

In the present application, by arranging the auxiliary weighted portions 56 corresponding to the interdigital transducer structure at corresponding positions on the reflective grating array 40, the reflection efficiency of the filter is further improved.

This embodiment may also be combined with any one or more features from other embodiments to obtain new structures, and all such resulting structures fall within the scope of protection of the present application.

### Embodiment 11:

This embodiment provides an electronic device. The electronic device includes any one of the filter structures according to embodiment 7 to embodiment 10.

In summary, the interdigital transducer structure, the filter structure, and the electronic device of the present application may suppress the transverse modes within the passband of an RF filter and reduce loss by arranging weighted connecting strips in the unipolar region and arranging the load structures in the interdigital region. Simultaneously, by staggeredly arranging the weighted connecting strips, transverse modes are further suppressed. Additionally, by cooperating with the provision of the weighted connecting posts, the weighted sub-portions, and the auxiliary weighted portions, the suppression effect on the transverse modes is further improved. Finally, by using the weighted transverse strips or the primary weighted portions as the load structures, the suppression effect on the transverse modes is further enhanced.

Therefore, the present application effectively overcomes various shortcomings of the prior art and possesses high industrial utility value.

The above embodiments are only illustrative of principles and efficacy of the present application and are not intended to limit the present application. Any person skilled in the art may modify or change the above embodiments without departing from spirit and scope of the present application. Therefore, all equivalent modifications or changes made by those having ordinary knowledge in the technical field without departing from the spirit and technical ideas disclosed in the present application shall still fall within the scope of the claims of the present application.

## Claims

1. An interdigital transducer structure, **characterized by** comprising: busbars, electrode fingers, weighted connecting strips, and load structures;
wherein the busbars comprise a first busbar and a second busbar arranged in parallel, the electrode fingers comprise first electrode fingers and second electrode fingers, wherein the first busbar is provided with a plurality of first electrode fingers, the second busbar is provided with a plurality of second electrode fingers; the plurality of first electrode fingers and the plurality of second electrode fingers are arranged opposite to each other at intervals in an intermediate region between the first busbar and the second busbar; an end of the electrode finger connected to the busbar is defined as a connecting end, and an end of the electrode finger away from the connecting end is defined as a free end;
a direction parallel to the first busbar is defined as a first direction, a direction perpendicular to the first direction and parallel to a plane in which the interdigital transducer structure lies is defined as a second direction, and a third direction is defined as being perpendicular to both the first direction and the second direction;
the intermediate region comprises an interdigital region and unipolar regions that do not belong to the interdigital region, wherein the interdigital region is a region formed between an edge of the free ends of the first electrode fingers and edges of the free ends of the second electrode fingers;
the weighted connecting strips are provided within the unipolar region, wherein the weighted connecting strip is located between the free end of the first electrode finger and the second busbar; and/or, the weighted connecting strip is located between the free end of the second electrode finger and the first busbar; and
a projection of the load structure on the electrode finger is spaced apart from the edge of the free end of the electrode finger by a preset distance in the second direction.

2. The interdigital transducer structure according to claim 1, wherein the load structures are primary weighted portions, wherein the primary weighted portions are respectively located on surfaces of the free ends of the first electrode fingers, and/or on surfaces of the second electrode fingers at positions corresponding to the free ends of the first electrode fingers in the first direction, and/or on surfaces of the free ends of the second electrode fingers, and/or on surfaces of the first electrode fingers at positions corresponding to the free ends of the second electrode fingers in the first direction.

3. The interdigital transducer structure according to claim 2, wherein each of the primary weighted portions comprises at least two weighted sub-portions arranged along the second direction.

4. The interdigital transducer structure according to claim 2, wherein the weighted connecting strips comprise a first weighted connecting strip and a second weighted connecting strip, the second weighted connecting strip and the second busbar are connected via a weighted connecting post at a position corresponding to the first electrode finger along the second direction; the first weighted connecting strip and the first busbar are connected via a weighted connecting post at a position corresponding to the second electrode finger along the second direction.

5. The interdigital transducer structure according to claim 4, wherein each weighted connecting post is provided with a secondary weighted portion.

6. The interdigital transducer structure according to claim 1, wherein the load structures are weighted transverse strips, wherein the weighted transverse strips are parallel to the first direction; one of the weighted transverse strips is arranged on a surface in the second direction close to the free end of the first electrode finger, and another of the weighted transverse strips is arranged on a surface in the second direction close to the free end of the second electrode finger.

7. The interdigital transducer structure according to claim 6, wherein in the interdigital region, auxiliary weighted portions are respectively arranged on the first electrode fingers and the second electrode fingers at positions close to two weighted transverse strips; and the auxiliary weighted portion is arranged between the two weighted transverse strips, or the auxiliary weighted portion is not arranged between the two weighted transverse strips.

8. The interdigital transducer structure according to any one of claims 1 to 7, wherein the weighted connecting strips comprise a first weighted connecting strip and a second weighted connecting strip, wherein projections of the first weighted connecting strip in the first direction coincide, and projections of the second weighted connecting strip in the first direction coincide;
Lengths of the first weighted connecting strip and the second weighted connecting strip parallel to the second direction are both 0.02λ-0.25λ, the minimum distance between each free end and its closest weighted connecting strip parallel to the second direction is 0.02λ-0.4λ, and the minimum distance between each free end and its closest busbar parallel to the second direction is 1λ-2λ; and
when the load structure is the primary weighted portion, a projection of each primary weighted portion on a plane in which the interdigital transducer structure lies, is located inside a projection of the electrode finger on which that primary weighted portion is located on the plane in which the interdigital transducer structure lies; a length of the electrode finger on which the primary weighted portion is located in the first direction is greater than a length of the primary weighted portion in the first direction; a length of each primary weighted portion parallel to the second direction is 0.5λ-1λ; and λ is a wavelength of a surface acoustic wave propagating within the interdigital transducer structure.

9. The interdigital transducer structure according to any one of claims 1 to 7, wherein the weighted connecting strips comprise first weighted connecting strips and second weighted connecting strips, wherein two adjacent first weighted connecting strips along the first direction are staggeredly distributed in the second direction, so that projections of the two adjacent first weighted connecting strips in the first direction do not coincide; two adjacent second weighted connecting strips along the first direction are staggeredly distributed in the second direction, so that projections of two adjacent second weighted connecting strips in the first direction do not coincide.

10. The interdigital transducer structure according to claim 9, wherein the minimum distances in the second direction between two adjacent first weighted connecting strips along the first direction and their corresponding second electrode fingers are respectively 0.02λ-0.4λ and 0.1λ-0.6λ, the minimum distances in the second direction between two adjacent second weighted connecting strips along the first direction and their corresponding first electrode fingers are respectively 0.02λ-0.4λ and 0.1λ-0.6λ, and lengths of the first weighted connecting strip and the second weighted connecting strip parallel to the second direction are both 0.02λ-0.25λ; wherein λ is a wavelength of a surface acoustic wave propagating within the interdigital transducer structure.

11. A filter structure, **characterized by** comprising the interdigital transducer structure according to any one of claims 1 to 10.

12. The filter structure according to claim 11, wherein the filter structure further comprises two reflective grating arrays, wherein the two reflective grating arrays are respectively arranged on both sides of the interdigital transducer structure along the first direction; each reflective grating array comprises at least two metal reflector strips and two sub-busbars, wherein the metal reflector strips are parallel to the second direction and arranged along the first direction; two ends of each metal reflector strip in the second direction are connected to two sub-busbars respectively; and reflective grating load structures are arranged on the reflective grating array at positions where projections of the load structures of the interdigital transducer structure in the first direction coincide.

13. The filter structure according to claim 12, wherein when the load structures of the interdigital transducer structure comprise primary weighted portions, the reflective grating load structures also comprise primary weighted portions, wherein the primary weighted portions of the reflective grating array are located on the metal reflector strips at positions corresponding to the primary weighted portions of the interdigital transducer structure in the first direction.

14. The filter structure according to claim 13, wherein when the primary weighted portion of the interdigital transducer structure comprises at least two weighted sub-portions, each primary weighted portion on the metal reflector strip also comprises at least two weighted sub-portions arranged along the second direction, wherein the weighted sub-portions of the reflective grating array are located on the metal reflector strip at positions corresponding to the weighted sub-portions of the interdigital transducer structure in the first direction.

15. The filter structure according to claim 12, wherein when the load structures of the interdigital transducer structure comprise weighted transverse strips, the reflective grating load structures also comprise weighted transverse strips, wherein the weighted transverse strips of the reflective grating array are connected to the weighted transverse strips of the interdigital transducer structure, and projections of the weighted transverse strips of the reflective grating array and the interdigital transducer structure in the first direction coincide.

16. The filter structure according to claim 15, wherein when the interdigital transducer structure is provided with an auxiliary weighted portion, the reflective grating array is also provided with an auxiliary weighted portion, and the auxiliary weighted portion of the reflective grating array is located at a position on the metal reflector strip corresponding to the auxiliary weighted portion of the interdigital transducer structure in the first direction.

17. An electronic device, **characterized by** comprising the filter structure according to any one of claims 11 to 16.
